# EUROPEAN PATENT APPLICATION

(11) **EP 1 850 399 A1**
(43) Date of publication of application: **31.10.2007**
(21) Application number: 06008504.0
(22) Date of filing: 25.04.2006
(51) Int. Cl.: H01L 33/00

(54) **Sealing structure for a white light emitting diode**

(71) Applicant: ILED Photoelectronics Inc., Wugu Township T'ai pei (TW)
(72) Inventor: Sun, Wei-Kuo, Songshan District Taipei City 105 (TW)
(74) Representative: Hauck Patent- und Rechtsanwälte

(57) **Abstract**

A sealing structure for a white light LED comprises a printed circuit layer located on a base, a cladding layer having a through hole is arranged on the printed circuit layer. A LED chip is received in the through hole and is electrically connected to the printed circuit layer by a welding wire. The through hole is filled with resin for sealing the LED chip and the welding wire and the surface of the printed circuit layer. A fluorescent film having well-distributed fluorescent substances is received in the through hole for covering the resin, and then an optical lens is laid over the fluorescent film and the cladding layer. Such structure can provide a white light LED light source with even brightness and luminance.

## Description

### BACKGROUND OF THE INVENTION

### Field of the Invention

The present invention relates to the LED (light emitting diode) field, and more particularly to a sealing structure for a white light LED.

### Description of the Prior Art

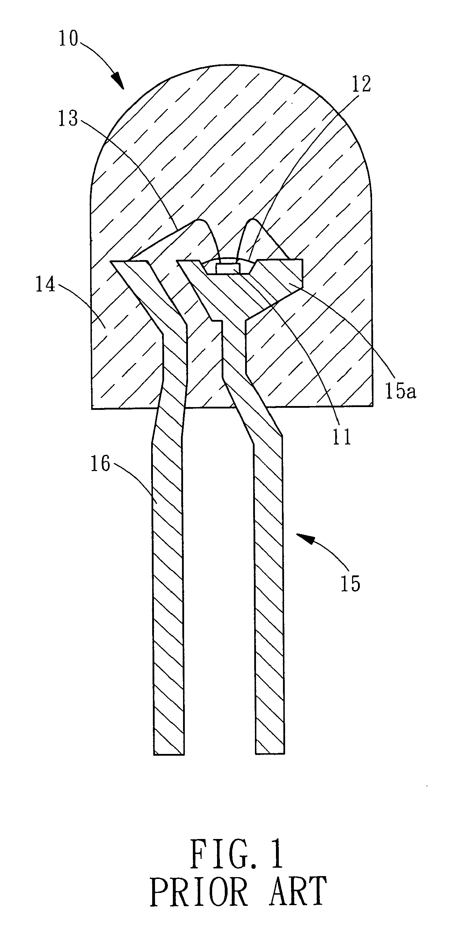

Referring to Fig. 1, a conventional LED structure is illustrated and comprises a light emitting diode (LED) 10, a light emitting element 11, a layer of resin coating 12, welding wires 13, sealing resin 14, a leading wire 15 and an inner leading wire 16.

As shown in Fig. 1, the LED 10 is a leading type LED with leading wire 15 and inner leading wire 16, wherein the light emitting element 11 is mounted on the coronal portion 15a of the leading wire 15, the resin coating 12 containing fluorescent substances is filled in the coronal portion 15a to seal the light emitting element 11.

However, the method of filling the coronal 15a and sealing the light-emitting element 11 with the fluorescent resin coating 12 has the problem that the fluorescent substances cannot be distributed evenly, causing uneven brightness and luminance of the LED 10.

The present invention has arisen to mitigate and/or obviate the afore-described disadvantages.

### SUMMARY OF THE INVENTION

The primary objective of the present invention is to provide a sealing structure for a white light LED that uses a well-distributed fluorescent film to provide an even white light.

Another objective of the present invention is to provide a sealing structure for a white light LED that can improve the acceptance rate of the sealing structure for a white light LED.

The present invention will become more obvious from the following description when taken in connection with the accompanying drawings, which show, for purpose of illustrations only, the preferred embodiments in accordance with the present invention.

### BRIEF DESCRIPTION OF THE DRAWINGS

Fig. 1 shows a conventional LED structure;
Fig. 2 is a cross sectional view of a sealing structure for a white light LED in accordance with a first embodiment of the present invention;
Fig. 3 is a perspective view of showing the cladding layer in accordance with a second embodiment of the present invention;
Fig. 4 is a sealing structure for a white light LED in accordance with the second embodiment of the present invention;
Fig. 5 is a perspective view of showing the cladding layer in accordance with a third embodiment of the present invention; and
Fig. 6 is a sealing structure for a white light LED in accordance with the third embodiment of the present invention.

### DETAILED DESCRIPTION OF THE PREFERRED EMBODIMENTS

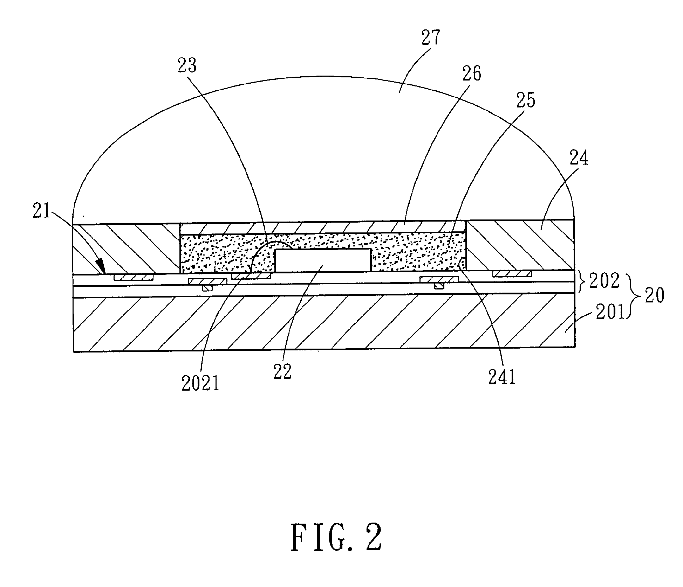

Referring to Fig. 2, a sealing structure for a white light LED in accordance with a first embodiment of the present invention is shown and generally comprises: a base 20, a chip 22, welding wire 23, a cladding layer 24, a resin 25, a fluorescent film 26 and an optical lens 27. The base 20 includes a substrate 201 and a printed circuit layer 202. The printed circuit layer 202 has an electrode-welding pad 2021 and is arranged on the substrate 201. The chip 22 is set on the surface 21 of the printed circuit layer 202. The cladding layer 24 having a through hole 241 is also located on the surface 21 of the printed circuit layer 202. The chip 22 is received in the through hole 241 of the cladding layer 24. The welding wire 23 has one end connected to the chip 22 and another end connected to the electrode welding pad 2021 on the printed circuit layer 202. The resin 25 is filled in the through hole 241 to seal the chip 22 and the welding wire 23, and then the resin 25 is covered with the fluorescent film 26 that is located in the through hole 241. The fluorescent film 26 is well produced with fluorescent substances well distributed. The optical lens 27 is larger than the through hole 241 and is mounted on the surface of the cladding layer 24.

The sealing structure for a white light LED in accordance with this embodiment utilizes the fluorescent film having well-distributed fluorescent substances to achieve the effect of providing a well-distributed fluorescent layer which can provide an even brightness and luminance, so as to solve the uneven distribution problem of the conventional fluorescent film, improving the acceptance rate of the sealing structure.

For a better understanding of the present invention, its operation and function, reference should be made again to Fig. 2.

The sealing structure for a white light LED in accordance with the present invention comprises: the base 20, the chip 22, the welding wire 23, the cladding layer 24, the resin 25, the fluorescent film 26 and the optical lens 27. The base 20 includes the substrate 201 and the printed circuit layer 202. The printed circuit layer 202 with the electrode-welding pad 2021 is arranged on the substrate 201. The chip 22 is set on the surface 21 of the printed circuit layer 202. The cladding layer 24 having the through hole 241 is also located on the surface 21 of the printed circuit layer 202. The chip 22 is received in the through hole 241 of the cladding layer 24. The welding wire 23 has one end connected to the chip 22 and another end connected to the electrode welding pad 2021 on the printed circuit layer 202. The resin 25 is filled in the through hole 241 to seal the chip 22, the welding wire 23, and a part of the printed circuit layer 202.

The fluorescent film 26 covers the resin 25 and is located in the through hole 241, and the fluorescent film 26 is well produced with fluorescent substances well distributed, so that the fluorescent film 26 can turn the color light from the chip 22 into white light. The optical lens 27 larger than the through hole 241 is mounted on the surface of the cladding layer 24.

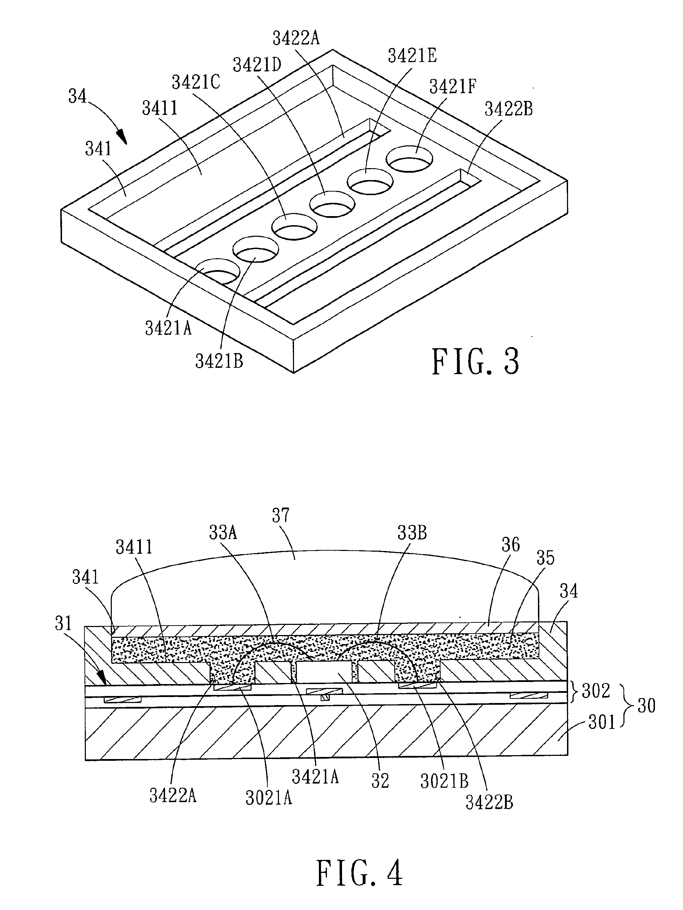

Referring to Figs. 3 and 4, Fig. 3 is a stereographic view of showing the cladding layer in accordance with a second embodiment of the present invention, and Fig. 4 is a sealing structure for a white light LED in accordance with the second embodiment of the present invention. This embodiment is slightly different from the first embodiment, and the differences are described as follows:

As shown in Fig. 3, a recess 341 is formed in the cladding layer 34, and the recess 341 has a flat bottom 3411. Six through holes 3421A, 3421B, 3421C, 3421D, 3421E and 3421F are arranged in line and defined in the center of the bottom 3411 of the recess 341. An elongated through hole 3422A, 3422B is defined at either side of the line of the through holes 3421A, 3421B, 3421C, 3421D, 3421E and 3421F.

The through holes 3422A and 3422B are adapted to receive the electrode welding pads 3021A and 3021B on the surface 31 of the printed circuit layer 302, and the electrode welding pads 3021A and 3021B will protrude out of the through holes 3422A and 3422B when the cladding layer 34 is placed on the surface 31 of the printed circuit 302.

As shown in Fig. 4, the difference of this embodiment with respect to the first embodiment as shown in Fig. 2 is the structure and the arrangement of the cladding layer 34 and the chip 32.

In this embodiment, the cladding layer 34 is located on the surface 31 of the printed circuit layer 302 in such a manner that the electrode welding pads 3021A and 3021B protrude out of the through holes 3422A and 3422B. The chip 32 is received in the through hole 3421A of the cladding layer 24. The welding wires 33A and 33B each has one end connected to the chip 32 and another end connected to the electrode welding pads 3021A and 3021B on the printed circuit layer 302 via the through holes 3422A and 3422B.

The resin 35 is filled in the recess 341 and the respective through holes 3421A, 3422A and 3422B to seal the chip 32, the electrode welding pads 3021A and 3201B, and the welding wires 33A and 33B. A well-distributed fluorescent film 36 is laid over the cladding layer 34 and the resin 35 and covers the recess 341. By such arrangement, the well-distributed fluorescent film 36 can convert the colored light emitting from the chip 32 into white light. And an optical lens 37 is placed on the fluorescent film 36.

The through hole 3421A in this embodiment is described above for purposes of example only, and in fact, each of the through holes 3421A, 3421B, 3421C, 3421D, 3421E and 3421F is received with a chip 32, and each chip 32 is provided with a welding wire 33A and 33B.

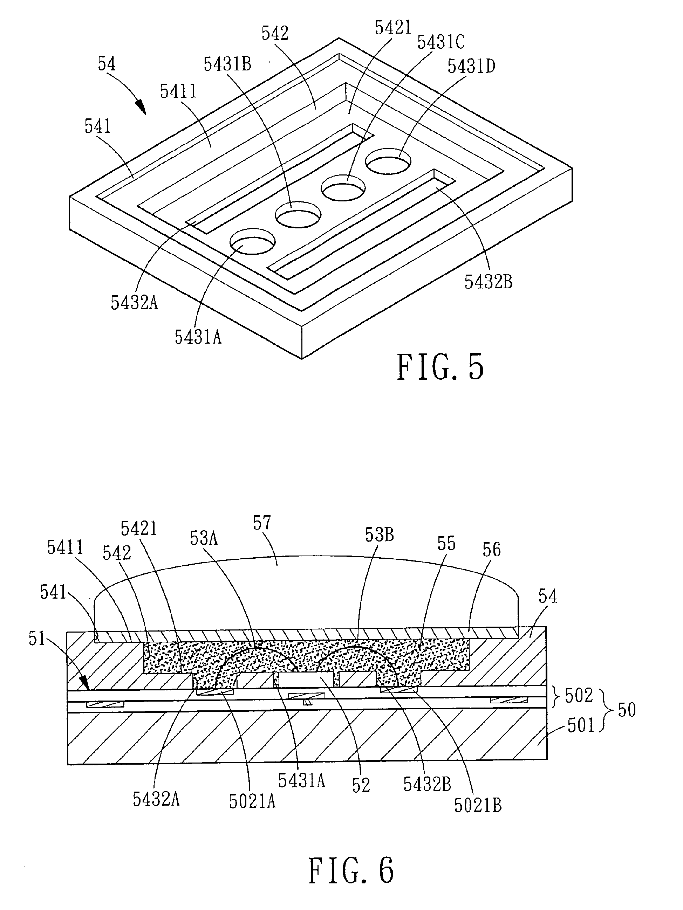

Referring then to Figs. 5 and 6, Fig. 3 is a perspective view of showing the cladding layer in accordance with a third embodiment of the present invention, and Fig. 4 is a cross sectional view of showing the sealing structure for a white light LED in accordance with the third embodiment of the present invention. This embodiment is slightly different from the first embodiment, and the differences are described as follows:

As shown in Fig. 5, a first recess 541 with a predetermined depth is defined in the surface of the cladding layer 54, and a second recess 542 smaller than first recess 541 is formed in the bottom 5411 of the second recess 542. Four through holes 5431A, 5431B, 5431C and 5431D are arranged in line and defined in the center of the bottom 5421 of the second recess 542. A rectangular through hole 5432A and 5432B is defined at either side of the line of the through holes 5431A, 5431B, 5431C and 5431D.

As shown in Fig. 6, two electrode welding pads 5021A and 5021B are arranged on the surface of the printed circuit layer 501 and are located correspondingly to the rectangular through holes 5432A and 5432B, and the electrode welding pads 5021A and 5021B will protrude out of the through holes 5432A and 5432B when the cladding layer 34 is placed on the surface 31 of the printed circuit 302.

The chip 52 is positioned in the through hole 5431A and is connected to the electrode welding pads 5021A and 5021B by the welding wires 53A and 53B, respectively. The resin 55 is filled in the second recess 542 and the through holes 5431A, 5431B, 5431C and 5431D, so as to seal the bottom 542, the welding wires 53A and 53B, and the chip 52.

A fluorescent film 56 with well-distributed fluorescent substances is placed in the first recess 541, so that it can convert the colored light emitting from the chip 52 into white light. And an optical lens 54 larger than the first recess 541 is placed on the cladding layer, thus forming a sealing structure for a white light LED.

According to the respective abovementioned embodiments, the well-distributed fluorescent film can be made by vacuum suction, powder at high pressure and high temperature, or spray coating method, spraying fluorescent substances to a transparent film, the bottom of a lens or to the cladding layer. The detail process of making the fluorescent film will be omitted. The resin in the respective embodiments can be replaced with other adhesive agents.

To summarize, the present invention utilizes the printed circuit layer used as a carrier for carrying power to the chip, and the well-distributed fluorescent film is arranged between the optical lens and the light emitting chip, thus forming a sealing structure for a white light LED. The well-distributed fluorescent film can convert the color light emitted from the chip into even white light, so as to solve the uneven distribution problem of the conventional fluorescent film.

While we have shown and described various embodiments in accordance with the present invention, it should be clear to those skilled in the art that further embodiments may be made without departing from the scope of the present invention.

## Claims

1. A sealing structure for a white light light emitting diode (LED) comprising:
a base including a printed circuit layer and a substrate, the printed circuit layer being arranged on the substrate, and at least one electrode welding pad arranged on the printed circuit layer;
at least one chip located on a surface of the printed circuit layer;
at least one welding wire for connecting the chip and the electrode welding pad on the printed circuit layer;
resin being located on the printed circuit layer for sealing the at least one chip and the at least one welding wire; and
at least one fluorescent film located on the surface of the resin for covering an area of the resin where the chip is located;
wherein the fluorescent film is a film whose fluorescent substances are evenly distributed.

2. The sealing structure for a white light light emitting diode (LED) as claimed in claim 1 further comprising a cladding layer having at least one through hole and being arranged on the printed circuit layer, the chip and the resin are received in the through hole;
wherein the fluorescent film is arranged in the through hole of the cladding layer and located on the resin.

3. The sealing structure for a white light light emitting diode (LED) as claimed in claim 1 further comprising a layer located on the surface of the fluorescent film.

4. The sealing structure for a white light light emitting diode (LED) as claimed in claim 3, wherein the layer is selected from the group consisted of transparent film, optical lens, and optical component.

5. The sealing structure for a white light light emitting diode (LED) as claimed in claim 3, wherein the layer is larger than the through hole of the cladding layer.
